# EUROPEAN PATENT SPECIFICATION

(11) **EP 3 709 008 B1**
(45) Date of publication and mention of the grant of the patent: **17.07.2024**
(21) Application number: 19163044.1
(22) Date of filing: 15.03.2019
(51) Int. Cl.: G01N 23/20025, G01N 23/20, G01N 23/2204, G01N 23/2206, G01N 23/2252, H01J 37/20

(54) **MEASUREMENT SYSTEM FOR EDS/TKD MEASUREMENT**
MESSSYSTEM ZUR MESSUNG VON EDS/TKD
SYSTÈME DE MESURE POUR MESURE EDS/TKD

(43) Date of publication of application: 16.09.2020
(73) Proprietor: Bruker Nano GmbH, 12489 Berlin (DE)
(72) Inventor: Goran, Daniel Radu, 12524 Berlin (DE)
(74) Representative: Gulde & Partner

(56) References cited:
- EP-A1- 2 824 448
- US-A1- 2018 374 671

## Description

The present invention refers to a measurement system for a combined energy dispersive spectroscopy, EDS, measurement and a transmission Kikuchi diffraction, TKD, measurement in an electron microscope, EM, the measurement system comprising a sample holder for placing a sample in the EM and further comprising an aperture extension configured to be mounted to the sample holder for improving signal to noise ratio, SNR, of the measurement.

### TECHNOLOGICAL BACKGROUND AND PRIOR ART

Energy dispersive spectroscopy, EDS, also called EDX, is the probably most commonly used X-ray analytic technique for characterizing the elemental composition of a sample based on characteristic X-rays emitted by the sample after being excited by an incident electron beam. EDS measurements are commonly carried out within electron microscopes, such as e.g., scanning electron microscopes, which comprise suitably configured EDS detectors inside a measurement chamber of the electron microscope. In the EM, the EDS detectors are often arranged upstream of the sample in the propagation direction of the electron beam.

Another analytic technique for measuring crystal orientation that can be integrated into an electron microscope is Kikuchi diffraction. This technique can be implemented as electron backscatter diffraction (EBSD), which is also known as backscatter Kikuchi diffraction (BKD), or as transmission Kikuchi diffraction (TKD), also known as transmission electron backscatter diffraction (t-EBSD). In EBSD, backscatter electrons are detected upstream the sample with respect to a propagation direction of an initially incident electron beam, whereas in TKD transmitted and diffracted electrons are detected downstream the sample in this direction. Both implementations can be theoretically applied to any crystalline material and provide the absolute crystal orientation with sub-micron spatial resolution and phase information.

To perform TKD measurements, samples have to be prepared as for transmission electron microscopy, TEM, i.e., the samples have to be electron transparent. The samples are then mounted horizontally or slightly tilted by a negative angle (e.g. 10 to 20 degrees) above the phosphor screen of the TKD detector. An electron beam hitting the upper side of the sample exits the sample through a lower surface (exit surface) after being diffracted by the sample. Thereby, a diffraction pattern of the electron transparent sample can be obtained with a lateral spatial resolution that is improved by an order of magnitude compared to EBSD.

A sample holder that can be advantageously used for performing a combined EDS and TKD measurement in an electron microscope is described and disclosed in the European patent EP 2 824 448 B1.

This sample holder has been developed to provide a practicable solution to fix a sample for the combined measurement in the EM without risking an unacceptable amount of shadowing. However, carrying out the combined measurements in practise showed that the signal of the EDS detector would be impeded by stray X-ray present in the measurement chamber. These stray X-rays would produce stray peaks in any EDS spectrum obtained by the EDS detector. Further, these stray X-rays would increase the input count rate of the EDS detector, while limiting the output count rate of proper signal, thus directly diminishing the signal to noise ratio, SNR, and hence the quality of EDS spectra obtained by the EDS detector.

US 2018/0374671 A1 discloses a sample holder for use in an electron microscope with a polepiece assembly and an X-ray detector, the sample holder comprising a shaft portion, a frame, a sample stage for holding a sample and a plurality of shield plates, wherein the frame is mounted to a front end of the shaft portion, surrounds the sample stage and comprises first to third portions, wherein the shield plates are mounted to said first to third portions.

The objective of the present application was thus to overcome or at least reduce the disadvantages of the prior art and to provide an improvement of the sample holder known from EP 2 824 448 B1 for combined EDS and TKD measurements that would allow for obtaining improved signals in such measurement, particularly improved EDS signals.

### DESCRIPTION OF THE INVENTION

The objective of the invention is solved and the disadvantages of the prior art are overcome by the subject-matter of the present invention, i.e., a measurement system of claim 1.

An aspect of the invention relates to a measurement system for a combined energy dispersive spectroscopy, EDS, and transmission Kikuchi diffraction, TKD, measurement, comprising a sample holder and an aperture extension as described in detail in the following.

The sample holder of the measurement system is configured for positioning a sample in an electron microscope (EM) that comprises an EDS detector and a TKD detector. Particularly, the sample holder (in conjunction with the EM) is configured for positioning the sample such that it is positioned in between the EDS detector and the TKD detector. Therein, the term 'in between' refers to a direction of propagation of the electron beam of the electron microscope.

According to the present invention, the sample holder comprises a main body with a tapered portion, wherein the tapered portion is terminating in a tip portion and wherein the tip portion is configured to receive the sample. The sample can be received directly or via a carrier.

The measurement system of the present invention further comprises an aperture extension having a basic configuration comprising an attachment portion and an aperture portion. Therein, the attachment portion is configured to be mechanically engaged with the main body of the sample holder for fixing the aperture extension to the sample holder and in a working position between the sample holder and one of the EDS and TKD detectors, preferably between the sample and the EDS detector. Further, the aperture portion is configured to extend laterally over the tip portion. In other words, the aperture portion comprises a larger width than the tip portion, whereas a height of the aperture portion perpendicular to that width is measured in the direction of propagation of the primary electron beam of the EM. The aperture extension can thus be mounted to the sample holder upstream or downstream with respect to the propagation direction of the electron beam, whereas upstream is preferred.

According to the present invention, the aperture extension comprises an aperture opening that is positioned in between the sample and the one of the EDS and TKD detectors, preferably in between the sample and the EDS detector, when the aperture extension is mounted to the sample holder to be in its working position. The aperture extension of the invention has the advantageous effect that it provides an easy solution for significantly lowering the amount of stray X-rays reaching the EDS detector. It has been found by the inventors that these stray X-rays are originating from the phosphor screen of the TKD detector below the sample. By providing the aperture extension to the sample holder, these X-rays get blocked by the aperture extension, particularly by the aperture portion extending laterally over the tip portion. At the same time, an EDS or TKD signal emanating from the sample can reach the EDS or TKD detector, respectively, through the aperture opening. Preferably, the aperture opening is configured for letting pass the EDS signal towards the EDS detector. Hence, by utilizing the measurement system of the present invention, simultaneous EDS and TKD measurements can be performed in an electron microscope with an improved signal to noise ratio, SNR.

According to a preferred embodiment of the measurement system, the aperture portion is configured to block X-rays that are propagating from a phosphor screen of the TKD detector towards the EDS detector. In detail, these X-rays are emitted by the phosphor screen in reaction to incident electrons, which might be either diffracted electrons emitted by the exit surface of the sample or other strayed or diffracted electrons. Obviously, preventing electrons to hit the phosphor screen of the TKD detector is counter productive, as these electrons may also be electrons carrying the TKD signal. Hence, the aperture portion is dimensioned such that it blocks X-rays that are propagating from a phosphor screen of the TKD detector towards the EDS detector. Particularly, at least the aperture portion or other parts of the aperture extension are dimensioned such that any X-ray propagating on a straight line drawn from any point of the phosphor screen to any point of the active area of the EDS detector hits a part of the aperture portion or another part of the aperture extension and terminates there.

Further preferred, the aperture opening is configured for letting through radiation propagating from the sample towards the one of the EDS and TKD detector. In other words, the aperture opening is preferably dimensioned such that an EDS signal can propagate from the sample to the EDS detector or that an TKD signal can propagate from the sample to the TKD detector. Therefore, the aperture opening is disposed above the sample in a plan view onto the top or bottom surface of the sample. Particularly preferred, the aperture opening is disposed above the sample in a plan view onto the top surface of the sample, wherein, in the plan view, the whole sample is disposed within the aperture opening. In other words, the aperture opening extends laterally over the sample in the working position of the aperture extension.

In the context of the present application, a lateral extension of the aperture extension, particularly of the aperture portion and the aperture opening, refers to a plane that is parallel, i.e., plane-parallel, to a contact plane of the sample holder. Therein, the contact plane of the sample holder is configured to receive the sample or, put otherwise, the planar sample is located fully within such contact plane once it is loaded to the sample holder. The extension of the aperture portion parallel to the contact plane is larger than the extension of the tip portion parallel to the contact plane and the aperture portion is overlapping the tip portion. The extension of the aperture opening parallel to the contact plane is larger than the extension of the sample parallel to the contact plane and the aperture opening is overlapping the sample.

In a particularly preferred embodiment of the measurement system, the aperture extension comprises a joint portion that is connecting the attachment portion and the aperture portion. Therein, the joint portion is preferably formed monolithically with the attachment portion and is formed monolithically with the aperture portion, i.e., the aperture extension forms a monolithic unit. In this embodiment, the joint portion is adapted to the shape of the tapered portion. Preferably, the joint portion is angled with respect to the aperture portion and is further angled with respect to at least part of the attachment portion. That is, in a side view, the aperture extension has a step-like shape, wherein, in a cross-sectional side view, at least part of the aperture portion is plane-parallel to at least part of the attachment portion.

In a particular preferred embodiment, the aperture opening extends into the joint portion. In other words, the aperture opening, i.e., part thereof, is disposed in the aperture portion and the aperture opening, i.e., part thereof, is disposed in the joint portion. As set forth above, the sample holder's tapered portion terminates in a tip portion configured to receive the sample. Hence, an aperture opening that shall extend laterally and omnidirectional over the sample might partially extend into the joint portion. By providing an aperture opening that extends laterally and omnidirectional (at least parallel to the contact plane) over the sample, it is ensured that an EDS signal emanating from any point of the sample can propagate to any point of an active area of the EDS detector without being blocked by the aperture extension. In other words, a favourably high solid angle for detecting the EDS signal from the sample is ensured.

In a further particularly preferred embodiment, the joint portion fits closely to the tapered portion in the working position of the aperture extension. Therein, the close fit might be achieved by providing an actual contact between the joint portion and the tapered portion in the working position or by providing a constantly small distance between the joint portion and tapered portion. In other words, a slope of the joint portion relative to the horizontal preferably equals the slope of the tapered portion relative to the horizontal. Put differently, the joint portion of the aperture extension is configured as matching counterpart to the tapered portion of the sample holder, i.e., a shape of the joint portion is adapted to a shape of the tapered portion.

By fitting the joint portion closely to the tapered portion, the aperture opening is disposed as closely as possible to the sample. Hence, the size of the aperture can be advantageously reduced without affecting the capturing solid angle of the EDS detector for the X-rays produced by the sample (or the solid angle for the TKD detector for the diffracted and transmitted electrons exiting the sample). Minimizing the size of the aperture is important as it directly influences the amount of stray X-rays produced by the phosphor screen and reaching the EDS detector. In other words, the amount of stray X-rays that reach the EDS detector and deteriorate the signal is directly proportional to the diameter of the aperture opening. Thus, closely fitting the joint portion to the tapered portion improves the signal to noise ratio of the EDS detector.

As set forth above, the sample holder is configured to receive the sample such that it is disposed in a contact plane once it is loaded to the sample holder. With respect to this contact plane, particularly considering the contact plane as an infinitely extended plane comprising the sample, the EDS detector is disposed above a first side of the contact plane and the TKD detector is disposed below a second side of the contact plane opposite to the first side. Therein, the first side of the contact plane is preferably facing an electron source of the electron microscope. As set forth above, the aperture portion preferably extends omnidirectional over the tip portion and parallely to the contact plane and the aperture opening extends omnidirectional over the sample and parallely to the contact plane as well.

According to a further preferred embodiment of the measurement system, the sample holder comprises a movable or rotatable element that is configured to fix the sample at the tip portion in a first position of the element and to load or unload the sample in a second position of the element. According to this embodiment, the attachment portion is configured to be mechanically engaged with the main body in the first position of the element. Preferably, the movable or rotatable element is configured to clamp the sample or the sample carrier. This prevents any movement of the sample or the sample carrier relative to the sample holder in a form-locking and/or force-locking manner. The rotatable element can be a hinged lever.

Particularly preferred, the tip portion comprises a seat for the sample that is restricting the movement of the sample within the contact plane. Therein, the seat may be configured to hold the sample or the sample carrier in all but one translational directions in a form-locking manner. The one translational direction is then used to facilitate sample loading. The seat can comprise or be a recess in a surface, preferably top surface, of the tip portion. Therein, the recess is adapted to the shape of the sample or sample carrier, particularly preferred to part of the shape of the sample or sample carrier. In other words, a sample or sample holder fixed inside the seat protrudes partially out of the seat, i.e., out of the tip portion.

According to a further preferred embodiment, the movable or rotatable element is configured to fix the sample or the sample carrier in at least one remaining translational direction inside the seat which is not restricted by the form-closure provided by the seat. In other words, the combination of seat and moveable/rotatable element provides a form and force closure of the sample in the sample holder in all directions. Further preferred, the movable or rotatable element covers the sample or the sample carrier solely at edge portions thereof. Thus an area of interest of the sample is not covered by the moveable or rotatable element.

Further preferred, the sample holder is configured to fix a sample or a sample carrier comprising the sample in a form-locking and/or a force-locking manner at or in the tip portion. Preferably, a maximum cross-section dimension (diameter) at the (very) front end of the tip portion is less than 15 mm, more preferably less than 10 mm, especially less than 8 mm.

The sample or the sample carrier are configured to perform TKD measurements and thus are at least partly electron transparent. Particularly preferred, they are prepared as for a use in a transmission electron microscope (TEM). The sample or the sample carrier can have a shape, which is at least partially circular, with a diameter of approximately 3 mm which is the standard size for TEM grids. For more details of the sample holder, such as e.g., the locking mechanism of the hinged lever, the sample and/or the sample carrier, it is referred to published EP 2 824 448 A1, the full disclosure of which is incorporated herein by reference.

Further preferred, the measurement system of the invention also comprises an electron microscope, EM, an EDS detector and a TKD detector. Therein the EM is configured to perform EDS measurements with the EDS detector and to perform TKD measurements with the TKD detector. Particularly preferred, the EM comprises at least one control unit that is configured for controlling an electron source, the EDS detector and/or the TKD detector. Preferably the electron microscope is a scanning electron microscope (SEM). Further preferred, the imaging detector and further preferred, the EM is configured to perform EDS measurements and TKD measurements in the same configuration. Further preferred, the same configuration is used for obtaining images with the imaging detector. Further preferred, the imaging detector is an in-column imaging detector that might be arranged inside a pole piece of an electron lens and/or between electron lenses of the column. In-column imaging detectors use secondary electrons (SE) and therefore may me named in-column SE detectors.

Further preferred, the EDS detector is a side entry detector that is positioned between the EM (SEM) pole piece and the sample and comprises a silicon drift detector, SDD. Particularly preferred, the EDS detector is an annular and/or four-channel SDD. Particularly preferred, the EDS detector is positioned such that an active detector area is oriented in parallel to the contact plane of the sample. Preferably, the active detector area is oriented horizontally. In a preferred embodiment, the EDS detector is a Bruker XFlash FlatQuad detector.

Also preferred, the TKD detector comprises at least a phosphor screen for converting incident electrons to photons and a CCD camera for obtaining image signals from these photons. Further preferred, the TKD detector further comprises a cooling system and is configured for operating at low temperatures for reducing the dark current of the CCD camera. Further preferred, an active detector area of the TKD detector, i.e., the phosphor screen, is positioned in parallel to the contact plane of the sample. Further preferred, the active area (phosphor screen) of the TKD detector is oriented in parallel (plane-parallel) to the active area of the EDS detector. Preferably, the phosphor screen is oriented horizontally. Particularly preferred, the sample is disposed between the active areas of the EDS and TKD detectors. Further preferred, the TKD detector is a Bruker e⁻Flash EBSD detector that is retrofitted for optimal measurement geometry with a Bruker Optimus TKD measuring head.

In a further preferred embodiment of the measurement system of the invention, the sample holder and the aperture extension are of the same material. Thus, no additional peaks are introduced in the EDS spectra obtained by the EDS detector by inserting the aperture extension into the measurement chamber of the electron microscope. Particularly preferred, the sample holder and the aperture extension are made of an Al-Mg alloy. However, other metals and/or alloys can be used, e.g., for measuring samples containing Al and/or Mg.

In a further preferred embodiment, the sample holder comprises a connecting member that is extending from a side of the main body, wherein this side is opposite to a side of the tapered portion. The connecting member comprises a pin stub that is configured for being stuck into a stage of the EM. This makes the sample holder advantageously compatible to stages of EMs. More preferably, an angle between a centre axis of the pin stub and the contact plane is greater than 90° and less than 180°. This enables to compensate a tilt-angle of a tilted stage of the EM used to prevent collisions between the stage and one of the detectors.

Another aspect of the present invention relates to an aperture extension for a measurement system according to the invention, as described above. The aperture extension comprises an attachment portion, a joint portion and an aperture portion and is preferably formed monolithically from an Al-Mg-alloy. The attachment portion comprises a U-shaped metal bar that has an opening width that is configured to provide a form closure and/or force closure with a main body of a sample holder of the measurement system. In other words, the attachment portion is configured to be slid over the main body of the sample holder such that the side legs of the U-shaped metal bar are closely fitting to side surfaces of the main body and such that an inner leg of the U-shaped metal bar is closely fitting to an upper surface, preferably a surface facing the EDS detector, of the main body. Therein, the side legs are connected to each other by the inner leg. Further preferred, the legs of the U-shaped metal bar may comprise further elements for engaging with the main body, such as e.g. snap segments protruding inwardly from the legs. Further preferred, the legs of the U-shaped metal bar further comprise handle portions configured for facilitating the handling of the aperture extension and protruding outward from the side legs.

The aperture portion of the aperture extension is formed monolithically with the attachment portion and comprises an aperture opening. The aperture opening is formed as a trough-hole penetrating the entire thickness of the aperture portion. The diameter of the aperture opening is adapted to the size of a sample such that it extends laterally and omnidirectional over the sample in a plane parallel to the sample when the aperture extension is mounted to the sample holder in a working position. However, the aperture opening is dimensioned as small as possible to block as many stray X-rays propagating from the phosphor screen towards the EDS detector, while allowing signals form the sample itself to reach the EDS/TKD detector.

The joint portion of the aperture extension is connecting the attachment portion and the aperture portion, is monolithically formed with the attachment portion and the aperture portion and further is bent from the attachment portion and from the aperture portion. In other words, the joint portion is angled with respect to the attachment portion and with respect to the aperture portion. Preferably, the aperture opening extends into the joint portion and further preferred the slope of the joint portion is matched to the slope of a tapered portion of the sample holder. This advantageously allows for closely fitting the joint portion of the aperture extension to the tapered portion of the sample holder in the working position of the aperture extension and thus allows for providing the aperture opening with a minimal size that ensures a maximal solid angle for the one of EDS or TKD measurement (depending on mounting the aperture extension upstream or downstream the sample holder in propagation direction of the beam), while blocking a maximum amount of stray X-rays propagating towards the EDS detector.

Further aspects and preferred embodiments of the present invention result from the dependent claims, the drawings and the following description of the drawings. Different disclosed embodiments are advantageously combined with each other if not stated otherwise.

### DESCRIPTION OF THE DRAWINGS

The features of the invention become apparent to those skilled in the art by the detailed description of exemplary embodiments with reference to the attached drawings in which:
- Figure 1: is slanted view of a prior art sample holder in a closed position with a sample;
- Figure 2: is a slanted view of the prior art a sample holder in a loading position;
- Figure 3: is a top view of the tip portion of the prior art sample holder;
- Figure 4: is a schematic drawing of a side view of the measurement system of the invention according to an embodiment;
- Figure 5: is a schematic drawing of a perspective bottom view of the measurement system of the invention according to an embodiment;
- Figure 6: is a schematic drawing of a perspective top view of the measurement system of the invention according to an embodiment;
- Figure 7: is a schematic drawing of a top view of the measurement system of the invention according to an embodiment;
- Figure 8: is a schematic drawing of a perspective top view of the aperture extension of the invention according to an embodiment;
- Figure 9: a combined ESD and TKD measurement system according to prior art; and
- Figure 10: a combined ESD and TKD measurement system according to an embodiment.

### DETAILED DESCRIPTION OF THE INVENTION

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art.

Accordingly, processes, elements, and techniques that are not considered necessary to those having ordinary skill in the art for a complete understanding of the aspects and features of the present invention may not be described.

As used herein, the term "and/or" includes any and all combinations of one or more of the associated listed items. Further, the use of "may" when describing embodiments of the present invention refers to "one or more embodiments of the present invention." In the following description of embodiments of the present invention, the terms of a singular form may include plural forms unless the context clearly indicates otherwise.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present invention. Expressions such as "at least one of," when preceding a list of elements, modify the entire list of elements and do not modify the individual elements of the list.

As used herein, the term "substantially", "about," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed using a numeric value, the term "substantially" denotes a range of +/- 5% of the value centered on the value.

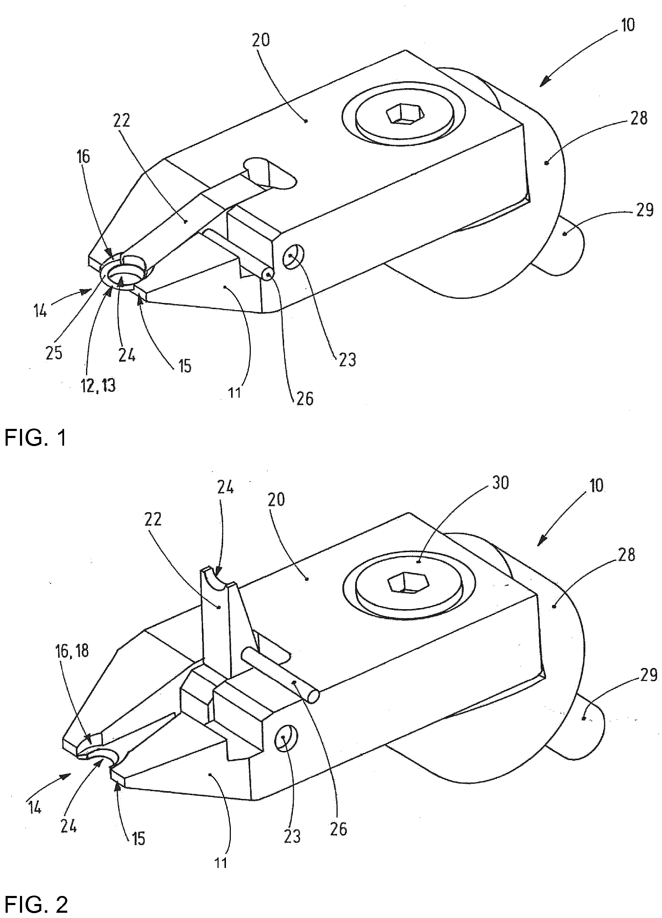

Figures 1 and 2 show a sample holder 10 according to the prior art as disclosed in EP 2 824 448 A1 for positioning a sample 12 or a sample carrier 13 inside an electron microscope (EM), which is configured to perform transmission Kikuchi diffraction (TKD) measurements in a slanted view from above. Figure 2 shows the sample holder 10 in a loading position, i.e., opened position for inserting a sample 12 and/or sample carrier 13. Figure 1 shows the sample holder 10 in a closed position, i.e., with an already loaded sample 12 (carrier).

The sample 12 and the sample carrier 13 are configured to perform TKD. They may be prepared as for a use in a transmission electron microscope (TEM) and thus may be at least partly electron transparent. Normally the sample 12 or the sample carrier 13 has an at least partially circular (disc-like) shape with a diameter of approximately 3 mm.

The sample holder 10 comprises a tip portion 14 and may be configured to fix the sample 12 or the sample carrier 13 in a form-locking and/or force-locking manner at or in the tip portion 14. The sample holder 10 may comprise a seat 16, which may form a contact plane 18 to receive the sample 12 or the sample carrier 13. The seat 16 is configured to hold the sample 12 or the sample carrier 13 in all but one translational directions in a form-locking manner.

As shown in Figure 1, the seat 16 may be a cavity in a main body 20 of the sample holder 10 in which the sample 12 or the sample carrier 13 may be inserted from above. The seat 16 may have a shape, such that a circular sample 12 or a sample carrier 13 protrudes from the tip portion 14, as can be seen in Figure 1.

Moreover the sample holder 10 comprises a movable or (as shown in the example) a rotatable element 22, which may be a hinged lever, and is configured to fix the sample 12 or the sample carrier 13. The rotatable element 22 may be mounted as to rotate around an axis 23 of the sample holder 10, which is mounted in the main body 20. The element 22 may be configured to fix the sample 12 or the sample carrier 13 in the remaining translational direction. Moreover the element 22 may clamp the sample 12 or the sample carrier 13, such that a play is eliminated.

The tip portion 14 may have a cut-out 24 that extends from a front end 15 of the tip portion 14 backwards, such that the sample 12 or the sample carrier 13 is covered only at its edge areas 25 that are laterally and backwardly directed, when the movable or rotatable element 22 is in the closed position. The sample holder 10 may comprise a handle 26, which is connected to element 22 and enables to open or to close the element 22 more easily.

The main body 20 may be connected to a connecting member 28 of the sample holder 10. The main body 20 and the connecting member 28 may be connected by a screw 30. The connecting member 28 is configured for being connected to a stage of an EM. Moreover, the connecting member 28 may be or comprise a pin stub 29, which may be stuck into the stage.

The tip portion 14 of the sample holder 10 has a tapered shape 44. The tapered shape 44 enables the sample holder 10 to be relatively slim at its front end of the tip portion 14. The tapered shape 44 at the side facing the pin stub (at the side below the sample 12 or the sample carrier 13 / at the same side with the transmitted signal) reduces shadowing while performing TKD measurements, while the tapered shape 44 at the side that faces away from the pin stub (at the top part) enables reducing a working distance (WD) between the sample 12 and the surface of a pole piece 62 (comprising electron lenses 61 of the EM) which is closest to the sample 12. The tapered shape 44 at both lateral sides improves the handling of the sample holder 10.

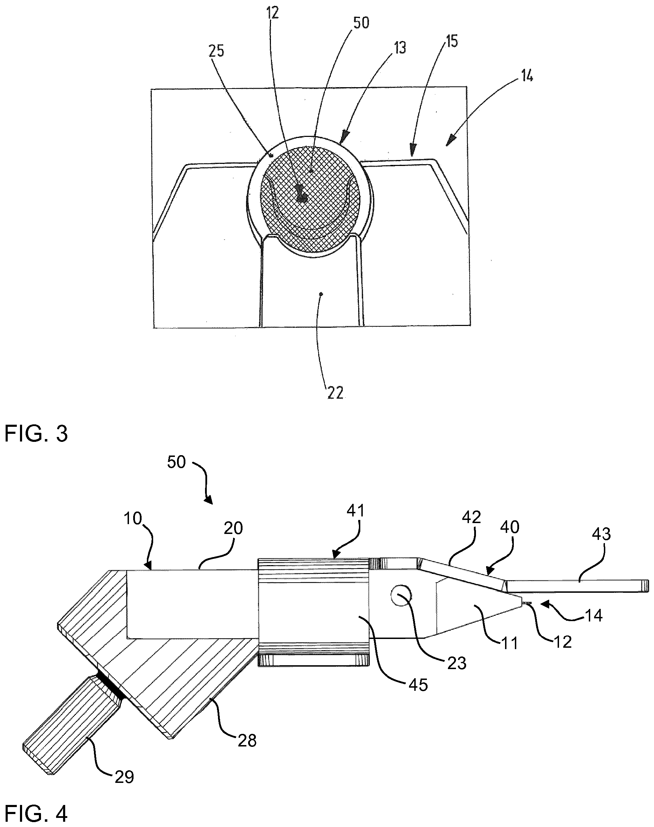

Figure 3 shows the tip portion 14 of the sample holder 10 in a top view in more detail and with a sample carrier 13, wherein the sample carrier 13 comprises a copper-grid 50 containing nanoparticles as a sample 12. The seat 16 fixes the sample 12 or the sample carrier 13 in a form-locking manner in all but one directions.

To mount a sample 12 or a sample carrier 13 the movable or rotatable element 22 of the sample holder 10 is in a loading position of Figure 2, thus the element 22 is turned away from the seat 16. The sample 12 or the sample carrier 13 may be placed into the seat 16 from above and is fixed by the seat 16 in a form-locked manner in all but the upward direction. This prevents the sample 12 or the sample carrier 13 from gliding of the sample holder 10. To fix the sample 12 or the sample carrier 13 inside the sample holder 10, the element 22 is turned towards the seat 16. This may be done by actuating the handle 26 into the closed position as shown in Figure 1.

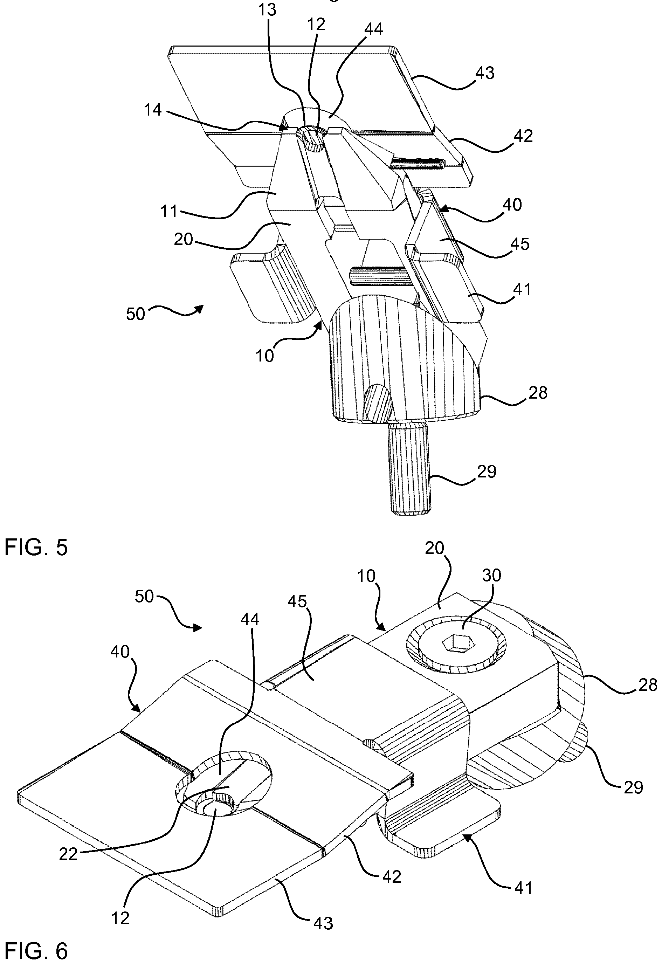

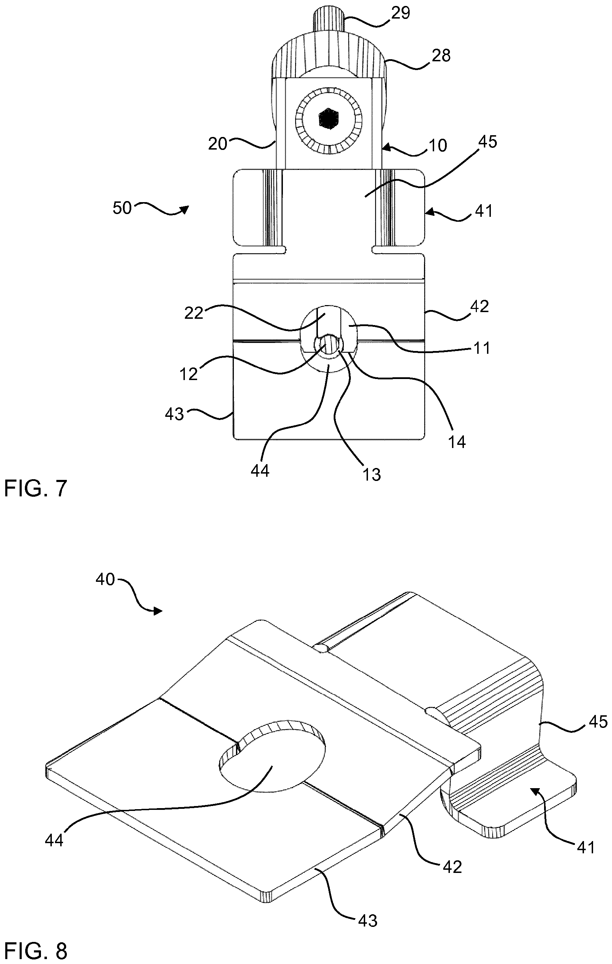

Figures 4 to 7 show schematic drawings of the measurement system 50 of the invention according to an embodiment in different perspectives. Particularly, Figure 4 shows a side view of the measurement system 50, Figures 5 and 6 show perspective bottom and top views of the measurement system 50, respectively, and Figure 7 shows a plan view thereof.

The measurement system 50 comprises the sample holder 10 as described in detail with respect to Figures 1 to 3. The measurement system 50 further comprises the aperture extension 40, a schematic drawing of a perspective top view of which is shown in Figure 8.

The aperture extension 40 as shown in Figure 8 is a monolithic metal piece made from an Al-Mg-alloy, which is the same material as that of the sample holder 10. The aperture extension 40 comprises an attachment portion 41 that comprises a bent metal bar, a section thereof forming a U-shaped metal bar 45. Further, two handle portions protrude outwardly from the side legs of the U-shaped metal bar 45 and are configured to simplify the handling of the attachment portion 41 and thus of the whole aperture extension 40. The opening width, i.e., the distance between the side legs of the U-shape or the extension of the inner leg connecting the side legs, is adapted to the size of the main body 20 of the sample holder 10. Therewith, the aperture extension 40 is adapted to be mounted to the main body 20 of the sample holder 10 via a force and/or form closure as described with respect to Figures 4 to 7.

The attachment portion 41 is monolithically formed with a joint portion 42 that is angled with respect to the attachment portion 41, particularly with respect to the inner leg of the attachment portion 41. In the embodiment as shown in Figure 8, the joint portion 42 comprises a first sub-portion that is plane-parallel to the inner leg of the attachment portion 41 that extends continuously into a second sub-portion that is angled with respect to the attachment portion 41, particularly with respect to the inner leg of the attachment portion 41. The angle between the joint portion 42 and the attachment portion 41, particularly between the second sub-portion of the joint portion 42 and the attachment portion 41, is identical to the angle of the tapered portion 11 of the sample holder 10, particularly with respect to the remaining main body 20 of the sample holder 10 in between tapered portion 11 and connecting member 28. This allows the joint portion 42 to fit closely to the tapered portion 11 as the aperture extension 40 is mounted to the sample holder 10 as described with respect to Figures 4 to 7.

The joint portion 42 is formed monolithically with an aperture portion 43 that is angled with respect to the joint portion 42, at least with respect to the second sub-section of the joint portion 42. The aperture portion 43 may have the same width as the joint portion 42. The aperture portion 43 is preferably oriented parallely to the contact plane 18 of sample holder 10. The aperture portion 43 comprises an aperture opening 44, i.e., a through hole, that extends also into the joint portion 42. The aperture opening 44 is positioned above the sample 12, if the aperture extension 40 is mounted in a working position to the sample holder 10 as it is shown in Figure 7 and described with respect to Figures 4 to 7.

In Figures 4 to 7 the aperture extension 40 is mounted to the sample holder 10 such that the aperture extension 40 is in its mounting position. Therein, the attachment portion 41 is slid over the main body 20 of the sample holder 10 in between the tapered portion 11 and the screw 30 such that the side legs of the U-shaped metal bar 45 are closely fitted to the side walls of the main body 20 and such that the inner leg of the U-shaped metal bar 45 is closely fitted to the top surface of the main body 20. Hence, the U-shaped metal bar 45 is attached to the main body 20 via a form closure and a force closure.

Mounted in the working position, the first sub-section of the joint portion 42 extends over the main body 20 until the point where it begins to narrow, i.e., to the beginning of the tapered portion 11 of the sample holder 10. At this point, the second sub-portion of the joint portion 42 starts, the shape of which is adapted to the shape of the tapered portion 11. Particularly, the joint portion 42 fits closely to the tapered portion 11, wherein a distance between the joint portion 42 and the tapered portion 11 remains constantly small. Alternatively, the joint portion 42 is mounted directly to the sample holder 10, i.e., without any distance between the first sub-section and the main body 20 and second sub-section and the tapered portion 11.

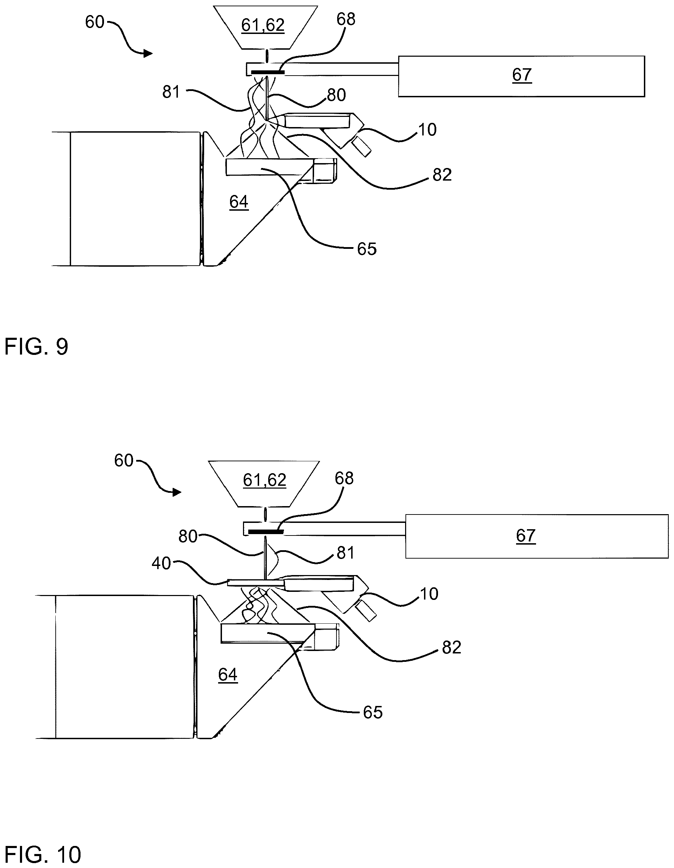

Mounted in the working position, the aperture opening 44 is disposed above the sample 12 and extends laterally and omnidirectional over the sample 12. Particularly, the sample 12 is positioned central within the aperture opening 44 in a plan view onto the sample 12. The aperture opening 44 thus extends into the joint portion 42 due to the size of the aperture opening 44. Hence, by providing the joint portion 42 with a shape that is adapted to the tapered portion 11, the diameter of the aperture opening 44 is advantageously reduced and hence its performance in blocking stray X-rays, while letting pass characteristic X-rays emitted from sample 12 is improved. This is described in more detail with respect to Figures 9 and 10.

Figures 9 and 10 illustrate combined EDS and TKD measurement systems mounted to an electron microscope 60, wherein Figure 9 denotes a system according to the prior art wherein Figure 10 denotes a system 50 according to an embodiment of the present invention.

According to Figures 9 and 10 an electron microscope, EM, 60, which is a scanning electron microscope (SEM), is configured to perform transmission Kikuchi diffraction (TKD) measurements. A pole piece 62, which is part of an electron lens 61 of the EM 60 is arranged at a column of the EM 60. Moreover the EM 60 comprises the sample holder 10 and a TKD detector 64, which comprises a phosphor screen 65. Moreover the EM 60 comprises an EDS (energy dispersive X-ray spectroscopy) detector 67. The EM 60 is configured to perform EDS measurements with the EDS detector 67 and to perform TKD measurements with the TKD detector 64. The sample 12 or the sample carrier 13, the column comprising the electron lenses 61 with the pole piece 62, the TKD detector 64 and the EDS detector 67 are arranged in a way, such that TKD measurements and EDS measurements can be made without changing the position of the sample holder 10, the column comprising the electron lenses 61 with the pole piece 62, the TKD detector 64 or the EDS detector 67.

In both Figures 9 and 10, an electron microscope 60, particularly a scanning electron microscope 60, comprises a sample holder 10 as described above. The sample holder 10 is positioned between the EDS detector 67 and the TKD detector 64 such that a sample 12 loaded to the sample holder 10 is positioned between an active area 68 of the EDS detector 67 and a phosphor screen 65 of the TKD detector 64. Particularly, the sample 12 is positioned between the EDS detector 67 and the TKD detector 64 with respect to the propagation direction of an electron beam 80, emitted by the electron microscope 60, particularly from a pole piece 62 of the EM 60, and focussed by a magnetic lens 61. Therein, the active area 68 of the EDS detector 67 is plane-parallel to the contact area 18 defined by the sample 12 loaded to the sample holder 10. Further, also the phosphor screen 65 of the TKD detector 64 is plane-parallel to the contact plane 18. In this context, the contact plane 18 is considered to contain the sample 12 and to extend laterally over the sample 12. With respect to such contact plane 18, preferably the normal directions of the contact plane 18, the active area 68 and the phosphor screen 65 are parallel to each other.

The sample 12 is prepared electron transparent such that at least part of the incident electron beam 80 is transmitted through the sample 12 and positioned such that the primary electron beam 80 is incident on the sample 12. Depending mostly on the sample thickness, material make-up and incident electron energy, the incident primary electrons are traversing the sample 12 and hence diffracted electrons 82 exit the sample 12 via an exit surface thereof facing the phosphor screen 65 of the TKD detector 64. These transmitted and diffracted electrons 82 allow for detecting Kikuchi patterns of the sample 12 via the TKD detector 64. Further, the incident primary electron beam 80 effects the generation of characteristic X-rays of the sample 12. The characteristic X-rays exiting the sample 12 via a top surface propagate towards the active area 68 of EDS detector 67, thus allowing for obtaining EDS spectra from the sample 12 and performing an element composition analysis on the sample 12.

The configuration of sample 12 and detectors 64, 67 as illustrated in Figure 9 advantageously enables simultaneous acquisition of Kikuchi patterns and EDS spectra at speeds, which can be at least one order of magnitude faster than with conventional detectors, using the same electron beam parameters. The main factor limiting the acquisition speed in combined TKD/EDS measurements is the reduced X-Ray signal resulting from the interaction of the incident beam 80 with the electron transparent sample 12 within a very small interaction volume. By using the EDS detector 67 that is positioned underneath the pole piece 67 and right above the electron transparent sample 12 it is advantageously possible to increase the X-ray capturing solid angle by up to two orders of magnitude and hence to increase the X-ray input count rate in a corresponding manner. The much higher X-Ray input/output count rate enables fast measurements without affecting the signal to noise ratio in the EDS spectra.

However, the transmitted and diffracted electrons 82 exiting the sample 12 towards the TKD detector 64 will inevitably hit the phosphor screen 65 of the TKD detector 64, where they can also effect the generation of characteristic X-rays 81 of the phosphor screen 65. These characteristic X-rays 81 can also propagate upwards towards sample 12 and, if they bypass the sample 12, can reach the active area 68 of the EDS detector 67 as stray X-rays. These stray X-rays are deleterious to the measurement in two ways: first they are producing "stray" peaks in the EDS spectrum which can interfere with the processing/quantification process and, second, they significantly increase the input count rate and therefore could limit the output count rate of the EDS detector 67 thus reducing the amount of useful counts originating from the sample 12 with a direct influence on the SNR or quality of the EDS spectrum.

In order to overcome the above-mentioned drawbacks of the prior art configuration as shown in Figure 9, the aperture extension 40 as shown in Figure 8 was developed for the sample holder 10 of Figures 1 to 2 in order to generate the measurement system 50 as shown in Figures 4 to7. The special design of the aperture extension 40 allows it to fit and to be easily fixed and removed onto or from the sample holder 10, respectively. The aperture extension 40 is further made of the same material as the sample holder 10 in order to avoid the production of additional peaks that could show up in any EDS spectrum. Further, the aperture extension 40, once mounted to its working position onto the sample holder 10, has the function of physically blocking stray X-rays originating from the phosphor screen 65.

Figure 10 shows the measurement system 50 of the invention mounted to the EM 60. As illustrated therein, the primary electron beam 80 can reach the sample 12 through the aperture opening 44 of the aperture portion 43 of the aperture extension 40. Hence, the diffraction of the incident electron beam 80 and the generation of characteristic X-rays 81 can occur in the sample 12 as described above with respect to Figure 9. With respect to the transmitted and diffracted electrons 82, the situation remains unchanged by the aperture extension 40 mounted between the sample 12 and the EDS detector 64 and they exit the sample 12 towards the TKD detector 64, where they enable the measurement of Kikuchi patterns and effect the generation of characteristic X-rays 81 of the phosphor screen 65.

However, these stray X-rays propagating upwards from the phosphor screen 65 are then blocked by the aperture extension 40, particularly by the aperture portion 43 and the joint portion 42, both extending laterally over the sample 12 and the tip portion 14 of the sample holder 10. Therefore, the aperture extension 40, particularly the aperture portion 43 and the joint portion 42, preferably extends such that any straight line connecting any point of the phosphor screen 65 with any point of the active area 68 of the EDS detector 67 will cross the aperture extension 40, particularly the aperture portion 43 or the joint portion 42. Therein, the size of the aperture extension 40 has to be adapted with respect to the size of the phosphor screen 65, the active area 68 and the mounting position of the sample holder 10 along the z-axis. The required calculations for determining the size, particularly the lateral extension of the aperture extension, are straight-forward and can be carried out by the skilled person. Advantageously, the majority of X-rays produced by the phosphor screen 65 below the sample 12 are blocked by the aperture extension 40 and hence the EDS spectra are improved.

Further, as the aperture extension 40 features the, preferably circular, aperture opening 44 that is positioned right above the electron transparent sample 12, any characteristic X-rays 81 generated by the sample 12 itself, can still reach the active area 68 of the EDS detector 67 and thus EDS measurements are not impeded by the aperture extension 40. Further, as the aperture extension's 40 shape was designed so that the joint portion 42 fits closely to the slope of the sample holder's 10 tapered portion 11, the aperture extension 40, particularly the joint portion 42, can be placed as close as possible to the sample 12. This advantageously allows reducing the size of the aperture opening 44 without affecting the capturing solid angle of the characteristic X-rays 81 produced by the sample 12. However, minimizing the size of the aperture opening 44 is important as it directly influences the amount of stray X-rays produced by the phosphor screen 65 that will still reach the EDS detector 67. In other words, the amount of stray X-rays still reaching the EDS detector 67 might be proportional with the diameter of the aperture opening 44 of the extension 40. Hence, the aperture extension 40 of the invention being adapted to the shape of the sample holder 10 advantageously allows for reducing the amount of stray X-rays reaching EDS detector 67.

### REFERENCE NUMBERS

- 10: sample holder
- 11: tapered portion
- 12: sample
- 13: sample carrier
- 14: tip portion
- 15: front end of the tip portion
- 16: seat
- 18: contact plane
- 20: main body
- 22: movable or rotatable element
- 23: axis on that the hinged lever is mounted
- 24: cut-out
- 25: edge area
- 26: handle
- 28: connecting member
- 29: pin stub
- 30: screw
- 40: aperture extension
- 41: attachment portion
- 42: joint portion
- 43: aperture portion
- 44: aperture opening
- 45: U-shaped metal bar
- 50: measurement system
- 60: EM / SEM
- 61: electron lens
- 62: pole piece
- 64: TKD detector
- 65: phosphor screen
- 67: EDS detector
- 68: active area of EDS detector
- 80: electron beam
- 81: characteristic X-rays
- 82: transmitted and diffracted electrons

## Claims

1. Measurement system (50) for a combined energy dispersive spectroscopy, EDS, and transmission Kikuchi diffraction, TKD, measurement, comprising:
a sample holder (10) for positioning a sample (12) in an electron microscope, EM, (60), the sample holder (10) having a main body (20) with a tapered portion (11) that is terminating in a tip portion (14) configured to receive the sample (12) such that the sample (12) is disposed on a contact plane (18); and
an aperture extension (40) having
an attachment portion (41) comprising a U-shaped metal bar (45) and being mechanically engaged with the main body (20) outside of the tapered portion (11) and the tip portion (14) in that side legs of the U-shaped metal bar (45) are closely fitted to side walls of the main body (20) and an inner leg of the U-shaped metal bar (45) is closely fitted to a top surface of the main body (20), wherein the attachment portion (41) is configured to fix the aperture extension (40) to the sample holder (10);
an aperture portion (43) extending laterally over the tip portion (14) in a plane that is plane-parallel to the contact plane (18) and overlapping the tip portion (14), wherein an extension of the aperture portion (43) parallel to the contact plane (18) is larger than an extension of the tip portion (14) parallel to the contact plane (18); and
an aperture opening (44) disposed on the aperture portion (43), having an extension parallel to the contact plane (18) that is larger than the extension of the sample (12) parallel to the contact plane (18) and overlapping the sample (12).

2. Measurement system (50) according to claim 1, wherein the aperture extension (40) comprises a joint portion (42) connecting the attachment portion (41) and the aperture portion (43), and wherein the joint portion (42) is adapted to the shape of the tapered portion (11).

3. Measurement system (50) according to claim 2, wherein the aperture opening (44) extends into the joint portion (42).

4. Measurement system (50) according to claim 2 or 3, wherein the joint portion (42) fits closely to the tapered portion (11).

5. Measurement system (50) according to any one of the preceding claims, wherein the aperture opening (44) extends laterally over the sample (12).

6. Measurement system (50) according to any one of the preceding claims, wherein the aperture portion (43) extends omnidirectional over the tip portion (14).

7. Measurement system (50) according to any one of the preceding claims, wherein the sample holder (10) further comprises a movable or rotatable element (22), configured to fix the sample (12) at the tip portion (14) in first position of the element (22) and to load or unload the sample (12) in a second position of the element (22), and wherein the attachment portion (41) is configured to be mechanically engaged with the main body (20) in the first position of the element (22).

8. Measurement system (50) according to any one of the preceding claims, wherein the sample holder (10) and the aperture extension (40) are of the same material.

9. Measurement system (50) according to any one of the preceding claims, wherein the sample holder (10) further comprises a connecting member (28) extending from a side of the main body (20) opposite to a side of the tapered portion (11) and comprising a pin stub (29) that is configured for being stuck into a stage (66) of the EM (60).

10. Measurement system (50) according to any one of the preceding claims, further comprising an electron microscope, EM, (60) an EDS detector (67), and a TKD detector (64), wherein the EM (60) is configured to perform EDS measurements with the EDS detector (67) and to perform TKD measurements with the TKD detector (64) and wherein the aperture extension (40) is fixed to the sample holder (10) in a working position between the sample holder (10) and one of the EDS (67) and TKD (64) detectors such that the aperture opening (44) is positioned in between the sample (12) and the one of the EDS (67) and TKD (64) detectors.

11. Measurement system (50) according to claim 10, wherein the aperture portion (43) is configured to block X-rays (81) propagating from a phosphor screen (65) of the TKD detector (64) towards the EDS detector (67).

12. Measurement system (50) according to claim 10 or 11, wherein the aperture opening (44) is configured for letting through radiation propagating from the sample (12) towards the one of the EDS (67) and TKD (64) detectors.

13. Measurement system (50) according to any one of claims 10 to 12, wherein the EDS detector (67) is disposed above a first side of the contact plane (18), and wherein the TKD detector (64) is disposed below a second side of the contact plane (18) opposite to the first side.

## Patentansprüche

1. Messsystem (50) zur kombinierten energiedispersiven-Spektroskopie-, EDS-, und Transmissions-Kikuchi-Beugungs-, TKD-, Messung, umfassend:
einen Probenhalter (10) zum Positionieren einer Probe (12) in einem Elektronenmikroskop, EM, (60), wobei der Probenhalter (10) einen Hauptkörper (20) mit einem sich verjüngenden Abschnitt (11) aufweist, der in einem Spitzenabschnitt (14) endet, der dazu ausgestaltet ist, die Probe (12) derart aufzunehmen, dass die Probe (12) auf einer Kontaktebene (18) angeordnet ist; und
eine Aperturerweiterung (40) mit
einem Anbringungsabschnitt (41), der einen U-förmigen Metallstab (45) umfasst und mit dem Hauptkörper (20) außerhalb des sich verjüngenden Abschnitts (11) und des Spitzenabschnitts (14) dadurch mechanisch in Eingriff steht, dass Seitenfüße des U-förmigen Metallstabs (45) nah an Seitenwänden des Hauptkörpers (20) befestigt sind und ein Innenfuß des U-förmigen Metallstabs (45) nah an einer oberen Oberfläche des Hauptkörpers (20) befestigt ist, wobei der Anbringungsabschnitt (41) dazu ausgestaltet ist, die Aperturerweiterung (40) an dem Probenhalter (10) zu fixieren;
einem Aperturabschnitt (43), der sich lateral über den Spitzenabschnitt (14) in einer Ebene, die planparallel zu der Kontaktebene (18) verläuft, erstreckt und den Spitzenabschnitt (14) überlappt, wobei eine Erweiterung des Aperturabschnitts (43) parallel zu der Kontaktebene (18) größer als eine Erweiterung des Spitzenabschnitts (14) parallel zu der Kontaktebene (18) ist; und
eine an dem Aperturabschnitt (43) angeordnete Aperturöffnung (44), die eine Erweiterung parallel zu der Kontaktebene (18), die größer als die Erweiterung der Probe (12) parallel zu der Kontaktebene (18) ist, aufweist und die Probe (12) überlappt.

2. Messsystem (50) nach Anspruch 1, wobei die Aperturerweiterung (40) einen Verbindungsabschnitt (42) umfasst, der den Anbringungsabschnitt (41) und den Aperturabschnitt (43) verbindet, und wobei der Verbindungsabschnitt (42) an die Form des sich verjüngenden Abschnitts (11) angepasst ist.

3. Messsystem (50) nach Anspruch 2, wobei sich die Aperturöffnung (44) in den Verbindungsabschnitt (42) erstreckt.

4. Messsystem (50) nach Anspruch 2 oder 3, wobei der Verbindungsabschnitt (42) nah an dem sich verjüngenden Abschnitt (11) befestigt ist.

5. Messsystem (50) nach einem der vorstehenden Ansprüche, wobei sich die Aperturöffnung (44) lateral über die Probe (12) erstreckt.

6. Messsystem (50) nach einem der vorstehenden Ansprüche, wobei sich der Aperturabschnitt (43) omnidirektional über den Spitzenabschnitt (14) erstreckt.

7. Messsystem (50) nach einem der vorstehenden Ansprüche, wobei der Probenhalter (10) ferner ein bewegliches oder drehbares Element (22) umfasst, das dazu ausgestaltet ist, die Probe (12) an dem Spitzenabschnitt (14) in einer ersten Position des Elements (22) zu fixieren und die Probe (12) in einer zweiten Position des Elements (22) aufzunehmen und abzugeben, und wobei der Anbringungsabschnitt (41) dazu ausgestaltet ist, mit dem Hauptkörper (20) in der ersten Position des Elements (22) mechanisch in Eingriff zu stehen.

8. Messsystem (50) nach einem der vorstehenden Ansprüche, wobei der Probenhalter (10) und die Aperturerweiterung (40) aus dem gleichen Material sind.

9. Messsystem (50) nach einem der vorstehenden Ansprüche, wobei der Probenhalter (10) ferner ein Verbindungselement (28) umfasst, das sich von einer Seite des Hauptkörpers (20) gegenüber einer Seite des sich verjüngenden Abschnitts (11) erstreckt und einen Stiftstumpf (29) umfasst, der dazu ausgestaltet ist, in einen Tisch (66) des EM (60) gesteckt zu werden.

10. Messsystem (50) nach einem der vorstehenden Ansprüche, ferner umfassend ein Elektronenmikroskop, EM, (60) einen EDS-Detektor (67) und einen TKD-Detektor (64), wobei das EM (60) dazu ausgestaltet ist, EDS-Messungen mit dem EDS-Detektor (67) durchzuführen und TKD-Messungen mit dem TKD-Detektor (64) durchzuführen, und wobei die Aperturerweiterung (40) an dem Probenhalter (10) in einer Arbeitsposition zwischen dem Probenhalter (10) und einem von dem EDS- (67) und dem TKD-Detektor (64) fixiert ist, sodass die Aperturöffnung (44) zwischen der Probe (12) und dem einen von dem EDS- (67) und dem TKD-Detektor (64) positioniert ist.

11. Messsystem (50) nach Anspruch 10, wobei der Aperturabschnitt (43) dazu ausgestaltet ist, Röntgenstrahlen (81) zu blockieren, die sich von einem Phosphorschirm (65) des TKD-Detektors (64) in Richtung des EDS-Detektors (67) ausbreiten.

12. Messsystem (50) nach Anspruch 10 oder 11, wobei die Aperturöffnung (44) zum Durchlassen von Strahlung, die sich von der Probe (12) in Richtung des einen von dem EDS- (67) und dem TKD-Detektor (64) ausbreitet, ausgestaltet ist.

13. Messsystem (50) nach einem der Ansprüche 10 bis 12, wobei der EDS-Detektor (67) über einer ersten Seite der Kontaktebene (18) angeordnet ist und wobei der TKD-Detektor (64) unter einer zweiten Seite der Kontaktebene (18) gegenüber der ersten Seite angeordnet ist.

## Revendications

1. Système de mesure (50) pour une mesure combinée par spectroscopie à dispersion d'énergie, EDS, et par diffraction de Kikuchi par transmission, TKD, comprenant :
un porte-échantillon (10) destiné au positionnement d'un échantillon (12) dans un microscope électronique, ME, (60), le porte-échantillon (10) présentant un corps principal (20) doté d'une partie tronconique (11) qui se termine en une partie formant pointe (14) conçue pour recevoir l'échantillon (12) de telle sorte que l'échantillon (12) est disposé sur un plan de contact (18) ; et
une extension de diaphragme (40) présentant
une partie fixation (41) qui comprend une barre métallique en forme de U (45) et qui est en prise de manière mécanique avec le corps principal (20) en dehors de la partie tronconique (11) et de la partie formant pointe (14), par le fait que des branches latérales de la barre métallique en forme de U (45) sont étroitement ajustées sur des parois latérales du corps principal (20) et une branche interne de la barre métallique en forme de U (45) est étroitement ajustée sur une surface supérieure du corps principal (20), la partie fixation (41) étant conçue pour fixer l'extension de diaphragme (40) au porte-échantillon (10) ;
une partie diaphragme (43) qui s'étend latéralement au-dessus de la partie formant pointe (14) dans un plan qui est plan-parallèle au plan de contact (18) et qui est superposée à la partie formant pointe (14), une extension de la partie diaphragme (43) parallèle au plan de contact (18) étant supérieure à une extension de la partie formant pointe (14) parallèle au plan de contact (18) ; et
une ouverture de diaphragme (44) disposée sur la partie diaphragme (43), présentant une extension parallèle au plan de contact (18) qui est supérieure à l'extension de l'échantillon (12) parallèle au plan de contact (18), et superposée à l'échantillon (12).

2. Système de mesure (50) selon la revendication 1, dans lequel l'extension de diaphragme (40) comprend une partie de jonction (42) reliant la partie fixation (41) et la partie diaphragme (43), et dans lequel la partie de jonction (42) est adaptée à la forme de la partie tronconique (11).

3. Système de mesure (50) selon la revendication 2, dans lequel l'ouverture de diaphragme (44) s'étend dans la partie de jonction (42).

4. Système de mesure (50) selon la revendication 2 ou 3, dans lequel la partie de jonction (42) s'ajuste étroitement sur la partie tronconique (11).

5. Système de mesure (50) selon l'une quelconque des revendications précédentes, dans lequel l'ouverture de diaphragme (44) s'étend latéralement au-dessus de l'échantillon (12).

6. Système de mesure (50) selon l'une quelconque des revendications précédentes, dans lequel la partie diaphragme (43) s'étend de manière omnidirectionnelle au-dessus de la partie formant pointe (14).

7. Système de mesure (50) selon l'une quelconque des revendications précédentes, dans lequel le porte-échantillon (10) comprend en outre un élément mobile ou rotatif (22), conçu pour fixer l'échantillon (12) sur la partie formant pointe (14) dans une première position de l'élément (22) et pour charger ou enlever l'échantillon (12) dans une seconde position de l'élément (22), et dans lequel la partie fixation (41) est conçue pour être en prise de manière mécanique avec le corps principal (20) dans la première position de l'élément (22).

8. Système de mesure (50) selon l'une quelconque des revendications précédentes, dans lequel le porte-échantillon (10) et l'extension de diaphragme (40) sont constitués du même matériau.

9. Système de mesure (50) selon l'une quelconque des revendications précédentes, dans lequel le porte-échantillon (10) comprend en outre un élément de liaison (28) s'étendant depuis un côté du corps principal (20) opposé à un côté de la partie tronconique (11) et comprenant un tronçon de tige (29) qui est conçu pour être enfoncé dans une platine (66) du ME (60).

10. Système de mesure (50) selon l'une quelconque des revendications précédentes, comprenant en outre un microscope électronique, ME, (60), un détecteur EDS (67) et un détecteur TKD (64), le ME (60) étant conçu pour effectuer des mesures EDS avec le détecteur EDS (67) et pour effectuer des mesures TKD avec le détecteur TKD (64) et l'extension de diaphragme (40) étant fixée au porte-échantillon (10) dans une position de travail entre le porte-échantillon (10) et l'un des détecteurs EDS (67) et TKD (64) de telle sorte que l'ouverture de diaphragme (44) est positionnée entre l'échantillon (12) et ledit détecteur des détecteurs EDS (67) et TKD (64).

11. Système de mesure (50) selon la revendication 10, dans lequel la partie diaphragme (43) est conçue pour bloquer des rayons X (81) qui se propagent depuis un écran phosphorescent (65) du détecteur TKD (64) vers le détecteur EDS (67).

12. Système de mesure (50) selon la revendication 10 ou 11, dans lequel l'ouverture de diaphragme (44) est conçue pour laisser passer un rayonnement se propageant depuis l'échantillon (12) vers ledit détecteur des détecteurs EDS (67) et TKD (64).

13. Système de mesure (50) selon l'une quelconque des revendications 10 à 12, dans lequel le détecteur EDS (67) est disposé au-dessus d'un premier côté du plan de contact (18) et dans lequel le détecteur TKD (64) est disposé en dessous d'un second côté du plan de contact (18) opposé au premier côté.
